# EUROPEAN PATENT APPLICATION

(11) **EP 4 675 675 A1**
(43) Date of publication of application: **07.01.2026**
(21) Application number: 24186142.6
(22) Date of filing: 02.07.2024
(51) Int. Cl.: H01L 21/768, H01L 21/3213

(54) **A METHOD FOR PRODUCING CONDUCTIVE LINES IN AN INTERCONNECT STRUCTURE OF A SEMICONDUCTOR CHIP**

(71) Applicant: Imec VZW, 3001 Leuven (BE)
(72) Inventor: Gupta, Anshul, 3000 Leuven (BE); Tokei, Zsolt, 3000 Leuven (BE); Decoster, Stefan, 3060 Bertem (BE); Delie, Gilles, 3150 Tildonk (BE); Kundu, Souvik, 3010 Kessel Lo (BE)
(74) Representative: Patent Department IMEC

(57) **Abstract**

A method is presented for producing an array of parallel conductive lines (10) in a first level of a multilevel interconnect structure of a semiconductor component. The lines are produced by direct etching, i.e. a conductive layer (2) is produced, a hardmask line pattern (4) is formed on the conductive layer and the line pattern is transferred to the conductive layer by etching the conductive layer relative to the hardmask lines. The hardmask lines are reduced in width prior to the pattern transfer. The width reduction is not done across the full line width of every line : at intended via locations, local hardmask pillars (5) are produced on the hardmask lines prior to the width reduction step, so that the original line width is maintained at the intended via locations. As a result, the width of the conductive lines obtained after the pattern transfer is smaller compared to prior art configurations, except in local areas corresponding to the locations of interconnect vias.

## Description

### Field of the Invention

The present invention is related to semiconductor processing, in particular to the formation of line-shaped conductors of a multi-level interconnect structure of a semiconductor chip.

### State of the art.

Semiconductor-based integrated circuits continue to evolve towards smaller and smaller dimensions, leading to ongoing processing challenges. Multilayer conductive structures are typically built as layers of conductive lines, with interconnect vias formed between lines of the respective layers. As dimensions shrink, the limitations of traditional lithography and etch processes such as dual damascene processing have become apparent.

In particular at the deepest levels of the multilayer structure, dual damascene has been increasingly replaced by direct metal etch techniques for producing parallel conductive lines. In direct metal etching, a pattern of parallel hardmask lines is formed on a metal layer and thereafter the pattern of the hardmask lines is transferred to the underlying metal. The technique also enables the formation of via connections which are self-aligned to the conductive lines, for example by locally removing the hardmask lines to create via openings and thereafter filling said openings with metal.

At low values of the conductive line pitch, in the order of a few tens of nanometres or lower, high electrical leakage of the line array has been measured. This issue is attributed to line-line shorting between neighbouring lines, which may be due to a number of reasons, including incomplete metal etching, remaining metal residues between the lines, or the oxidation of the hardmask lines. The oxide formation may bridge the gap between neighbouring hardmask lines and lead to line-line shorting when the hardmask lines contain a conductive metallic component.

### Summary of the invention

The invention aims to provide a solution to the problems indicated hereabove. This aim is achieved by a method according to the appended claims. The invention is thus related to a method for producing an array of parallel conductive lines in a first level of a multilevel interconnect structure of a semiconductor component. The 'first level' does not refer necessarily to the deepest level of the interconnect structure, but it can refer to any level within the structure that has a second level above said first level. Throughout this description and in the claims, the term 'conductive' is intended to refer to 'electrically conductive'.

The lines are produced by direct etching, i.e. a conductive layer is produced, a hardmask line pattern is formed on the conductive layer and the line pattern is transferred to the conductive layer by etching the conductive layer relative to the hardmask lines. However, contrary to existing methods, the hardmask lines are reduced in width prior to the pattern transfer. The width reduction is however not done across the full line width of every line : at intended via locations, local hardmask pillars are produced on the hardmask lines prior to the width reduction step, so that the original line width is maintained at the intended via locations. As a result, the width of the conductive lines obtained after the pattern transfer is smaller compared to prior art configurations, except in local areas corresponding to the locations of interconnect vias. The smaller width implies an increased distance between adjacent lines, which is beneficial in terms of reducing the risk of line-line shorting issues.

The invention thereby enables reducing at least some of the causes of leakage-related problems, especially at the deeper levels of the interconnect structure, while maintaining suitable resistance values of the interconnect vias.

The invention is in particular related to a method for producing an array of parallel conductive lines in a first and second level of a multilevel interconnect structure of a semiconductor component, the method comprising the steps of :
- providing a substrate comprising a planar surface formed primarily of dielectric material,
- producing on said planar surface a layer of electrically conductive material,
- producing a hardmask pattern in the form of parallel lines on the layer of conductive material,
- producing at least one local hardmask pillar that fully overlaps at least one of said parallel hardmask lines, at an intended location of an interconnect via for connecting a conductive line in said first level to a conductive line in a second level directly above the first level,
- reducing the width of the parallel hardmask lines except at the location of the at least one local hardmask pillar,
- removing the at least one local hardmask pillar, leaving a modified hardmask line pattern comprising hardmask lines which are wider at the location or locations at which the at least one hardmask pillar was present, than outside said pillar location or locations,
- transferring the modified hardmask line pattern to the layer of conductive material by etching, thereby obtaining parallel conductive lines, at least one of said lines comprising one or more local line portions having a higher width than the line width outside said local line portions,
- producing dielectric material between the conductive lines and planarizing said dielectric material and the hardmask line pattern to a common planar surface,
- removing the material of the hardmask lines at the intended one or more via locations, to thereby obtain one or more via openings in said common planar surface, exposing one or more conductive lines of the first level at the bottom of the respective one or more via openings,
- filling the one or more via openings with a conductive material to thereby obtain one or more interconnect vias suitable for connecting said conductive lines of the first level to conductive lines of the second level,
- producing said conductive lines of the second level, at least some of which are connected to conductive lines of the first level by one or more of said interconnect vias.

According to an embodiment, the step of reducing the width of the hardmask lines is done by :
- oxidizing the hardmask lines so that in an outer layer of the hardmask lines, the hardmask material is replaced by an oxide layer,
- removing the oxide layer by etching the oxide layer selectively with respect to the hardmask material of the hardmask lines.

According to an embodiment, said layer of conductive material comprises a bottom layer, an etch stop layer directly on the bottom layer and a top layer directly on the etch stop layer, wherein :
- the etch stop layer stops an etch process applied for transferring the hardmask line pattern to said top layer,
- after transferring the hardmask line pattern to the top layer, the line pattern is further transferred by etching to the etch stop layer itself and to the bottom layer.

According to an embodiment, said first and second level of the multilevel interconnect structure belong to the three deepest levels of the interconnect structure.

According to an embodiment, the layer of conductive material comprises or consists of Ru, Wo or Mo and wherein the hardmask material used for forming the parallel hardmask lines is SiN or SiO₂.

The invention is equally related to a semiconductor component comprising a multilevel interconnect structure, including a first level and a second level, each comprising an array of parallel conductive lines and one or more interconnect vias connecting conductive lines of the first level to conductive lines of the second level, characterized in that at least one of the conductive lines of the first level comprises one or more local line portions having a higher width than the line width outside said local line portions, and wherein one or more of said interconnect vias are located at the locations of said local line portions, said interconnect vias being defined by a width in the direction perpendicular to the conductive line and by a length in the longitudinal direction of said line, and wherein :
- said via width is equal to and aligned to the width of the local line portions,
- said via length is at least equal to the length of the local line portions.

According to an embodiment of a component according to the invention, said first and second level of the multilevel interconnect structure belong to the three deepest levels of the interconnect structure.

### Brief description of the figures

Figures 1 to 10 illustrate a process flow representative of a first embodiment of the method according to the invention.
Figures 11 to 15 illustrate an alternative embodiment of the method according to the invention.
Figure 16 visualizes the characteristic features of an interconnect structure in a semiconductor component according to an embodiment of the invention.

### Detailed description of the invention

One embodiment of the method of the invention will now be described in detail. Any reference to material choices and dimensions is included by way of example only and does not limit the scope of the invention, which is defined only by the appended claims.

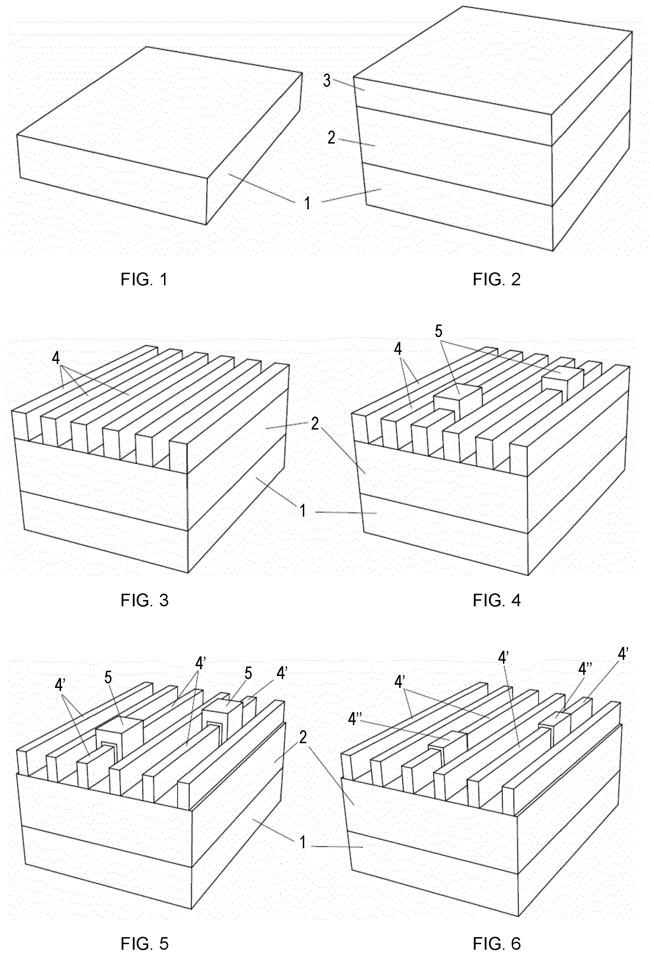

Figure 1 shows a small section of a substrate 1 which may be a nano-sized upper slice of a silicon process wafer after the front end of line (FEOL) processing. As is known to the person skilled in the domain of semiconductor processing, the FEOL process constitutes a sequence of processing steps for producing large numbers of semiconductor devices such as transistors and diodes on usually a silicon wafer, according to the layout of several integrated circuit chips. BEOL processing adds a multi-level interconnect structure on top of the FEOL portion of the chips, said interconnect structure comprising multiple levels of electrically conductive lines, interconnected according to a predefined interconnection scheme by vertical interconnects, referred to in the present description as 'interconnect vias'. The interconnect levels are usually labelled Metal0, Metal1, Metal2, etc (in short M0, M1, M2, etc), as the line and via material is usually a metal such as Ru or W for the deepest levels and Cu for the higher levels. The deepest level M0 includes connections in direct contact with the active devices in the FEOL portion and is also referred to as the Middle of Line portion (MOL) of an integrated circuit.

The top surface of the substrate 1 is primarily formed of a dielectric material, for example SiO₂ or low-K dielectric onto which surface the conductive lines of interconnect level M0 are to be formed. Embedded in said dielectric layer are electrical conductors or contacts (not shown), connected for example to source or drain electrodes of transistors of the FEOL portion.

The described embodiment is related to the formation of conductive lines of level M0 and to interconnect vias for connecting said lines to the level M1, but the same method is applicable for forming conductive lines of any level Mi and interconnect vias towards the lines of level Mi+1 for i = 0, 1, 2, 3, ..

Two layers are produced on the planarized top surface of the base portion 1, as illustrated in Figure 1. The first layer 2 is an electrically conductive layer, preferably formed of a metal. For the deep levels of the BEOL (for example i = 0 to 3) this may for example be a layer of Ru, W or Mo. For some materials, such as for Ru, it may be required to provide a conductive adhesion layer such as a thin titanium nitride (TiN) layer between the substrate 1 and the Ru layer 2. Such an adhesion layer is however not shown in the illustrated example flow. The thickness of the conductive layer 2 is in the order of 25-30 nm in the represented exemplary drawings, but this thickness may be higher, for example up to 60nm.

On top of the conductive layer 2, a layer 3 of hardmask material is formed. A thin TiN adhesion layer (not shown) may again be provided between the conductive layer 2 and the layer 3.

With reference to Figure 3, the layer 3 of hardmask material is then patterned according to a parallel line pattern formed of hardmask lines 4 of equal width. The method is described hereafter for line widths of the lines 4 of about 9nm, but the invention is applicable to any practicably applicable line width. In this exemplary case, the width of the trenches between adjacent lines is also about 9 nm, so that the pitch of the array is about 18nm. A suitable hardmask material for this purpose is silicon nitride (hereafter abbreviated as SiN). Another option is SiO₂ as the hardmask material. Techniques for producing the hardmask lines 4 at these small dimensions are well known in the art, and may include double or higher multiple patterning techniques, details of which are well known to the skilled reader. The length of the hardmask lines 4 depends on the particular layout and may be in the order of several tens of micrometres for example.

According to prior art techniques, the hardmask line pattern is then transferred to the underlying metal layer 2 to obtain an array of conductive lines by direct metal etching. According to the invention however, a number of process steps are performed prior to said pattern transfer.

With reference to Figure 4, hardmask pillars 5 are produced locally at a plurality of locations. These locations are the intended locations of interconnect vias which will connect the conductive line array of level M0 to the overlying line array of level M1. In the direction perpendicular to the hardmask lines 4, the hardmask pillars 5 overlap respective hardmask lines, i.e. each pillar 5 straddles at least one hardmask line 4 in the direction perpendicular to said line. In the direction parallel to the hardmask lines 4, the length of the pillars 5 is at least the length of the respective intended interconnect vias in the intended locations, as will be described later in this text.

The hardmask material applied for the pillars 5 may be any material suitable for use at the relevant dimensions. At the deepest M0 level for example, it is preferred to apply EUV (extreme ultra-violet) lithography using a negative tone resist material, which may be applied on an SOG/SOC stack (spin-on-glass/spin-on-carbon). Such lithography processes are known to the skilled reader and therefore not described in detail in the present context.

With the hardmask pillars 5 in place, shrinking of the hardmask lines 4 is now performed, as illustrated in Figure 5. For example, shrinking is performed to the extent that the width of the hardmask lines 4 is reduced by about 2 nm and the height is reduced by about 1 nm. One way of realizing this in the case of SiN hardmask lines 4 is by subjecting the lines to an oxidization step, whereby an outer layer of the SiN lines 4 of about 1nm thick is oxidized, i.e. a 1nm thick silicon dioxide layer replaces the outer 1nm of SiN. Known methods for realizing the oxidization can be applied, for example exposure during a few seconds to an oxygen-based plasma in a dry etch plasma etch tool, at room temperature and at a typical pressure applicable for dry etching. Other known approaches are possible, such as heating under oxidizing conditions or exposure to ozone (Os). Thereafter, the silicon dioxide is selectively removed relative to the remaining SiN, leaving the SiN lines which have shrunk on each side and at the top by about 1 nm. This can be done by a known dry or wet etch recipe exhibiting a suitable etch selectivity for removing silicon dioxide relative to SiN. A suitable dry etching process is fluor-based reactive ion etching. Wet etching is possible using a diluted HF (hydrofluoric acid) treatment.

Other known methods may however be applied to realize the shrinking step, depending on the material of the hardmask lines for example.

The width and height of the hardmask lines is thereby reduced, except underneath the hardmask pillars 5, i.e. at the intended locations of the interconnect vias.

With reference to Figures 5 and 6, the hardmask pillars 5 are stripped relative to the material of the hardmask lines 4. The result is a modified pattern of hardmask lines, comprising reduced line portions 4', having a reduced width compared to the original lines 4 of about 7nm and a reduced height, and local non-reduced line portions 4" at the intended via locations, where the hardmask lines have retained their original width of about 9nm, and their original height. The non-reduced line portions 4" are 'local' in the sense that they extend on a small portion of the total line length, for example exceeding not more than one or two percent of said total line length. Some of the lines 4 may be reduced across their full length, if no interconnect vias are intended to be placed on said lines.

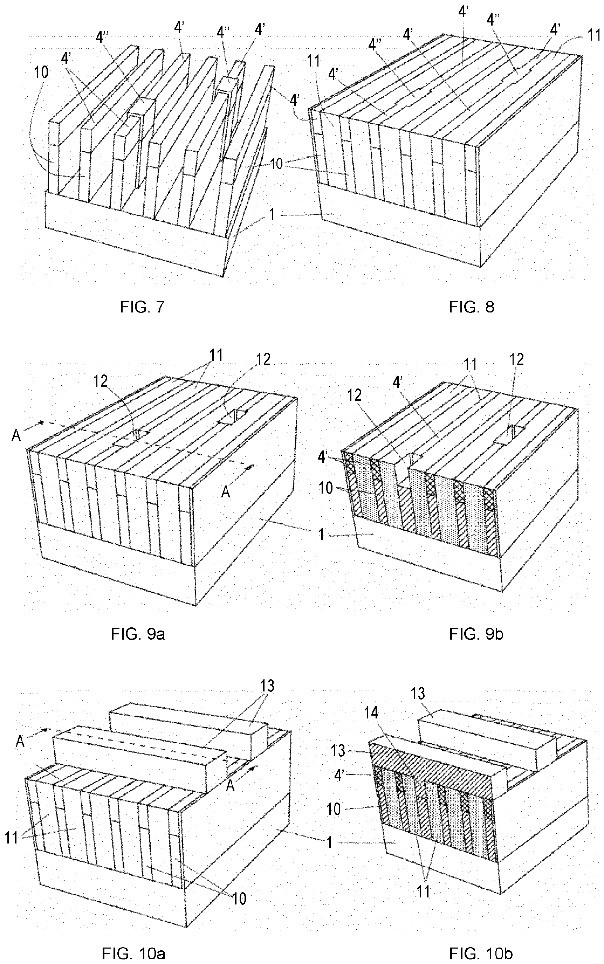

The modified hardmask line pattern is now transferred to the underlying metal layer 2, as illustrated in Figure 7, by an anisotropic etch process.. This is preferably done by dry etching, for example reactive ion etching. It is seen that conductive lines 10 are thereby formed, having a width of about 7nm, except at the intended via locations, where the line width is about 9nm. The pattern transfer process is an essentially anisotropic etching process wherein the material of layer 2 is removed in trenches defined by the distances between the hardmask lines. The image shows the rather theoretical case wherein the sidewalls of the conductive lines 10 are perfectly vertical. In reality, a small deviation from this vertical orientation is allowed.

The height of the conductive lines 10 corresponds to the thickness of the original conductive layer 2, i.e. about 25-30 nm in the represented case, which implies a conductive line aspect ratio of about 4 outside the intended via locations. As stated, the conductive layer 2 may have a higher thickness than 25-30nm, and higher aspect ratios (for example up to 6 or 7) are achievable with currently available litho and etch technology.

The hardmask lines 4',4" are represented as retaining their original height after the pattern transfer step. In reality, the height of the hardmask lines may be reduced during the etch process for forming the conductive lines 10, compared to their original height, as some of the hardmask material may be consumed during etching.

Then, with reference to Figure 8, a dielectric material 11 is deposited in the trenches between the aggregate lines, i.e. the lines formed of the conductive lines 10 and the hardmask lines 4',4" on top of said conductive lines. The dielectric 11 may be any material suitable for isolating conductive lines in a BEOL structure, such as silicon dioxide or low-K materials. Depending on the material and deposition technique used, the dielectric may fill the trenches between the lines completely from the bottom up, or air gaps may be created between adjacent lines. Air gap formation at the lower end of the trenches is often desired as it improves electrical isolation between the lines and reduces the capacitance of neighbouring metal lines. The dielectric however fills the width of the trenches fully in an area near the top of the aggregate lines.

As illustrated in Figure 8, the dielectric material is planarized to a common level with the hardmask lines 4',4", resulting in a planarized surface at said common level, wherein the hardmask lines are exposed in said surface. Standard planarization methods such as chemical mechanical polishing (CMP) recipes can be applied for this purpose. The planarization removes the height difference between the non-reduced line portions 4" and the reduced line portions 4'.

At the intended locations of the interconnect vias, the hardmask material is now locally removed in the areas 4" where the hardmask lines have retained their original width, as illustrated in Figure 9a and in the 3D section view in Figure 9b. The section plane A-A passes through one of the via locations. The local removal of the hardmask material can be done by lithography and etching according to known litho and etch recipes based on a predefined layout of the via locations. If an adhesion layer was present between the conductive layer 2 and the hardmask layer 3, this adhesion layer is also removed locally. A number of via openings 12 are thereby created, wherein the upper surface of respective conductive lines 10 is exposed at the bottom of said via openings 12.

In the embodiment shown, the length of the via openings 12 in the longitudinal direction of the lines 4' is the same as the length of the non-reduced line portions 4", and the via openings 12 are perfectly aligned to said non-reduced line portions 4" in said longitudinal direction. The via openings 12 could however be shorter and/or slightly misaligned in this longitudinal direction compared to the non-reduced line portions 4", as long as via openings 12 are created that enable the formation of an interconnect via of sufficient length in said longitudinal direction. The width of the via openings 12 in the direction perpendicular to the lines 4', is determined by the width of the non-reduced line portions 4", i.e. about 9nm in the particular case illustrated in the drawings. In said perpendicular direction, the via openings 12 are thereby self-aligned to the width of the conductive lines 10.

The via openings 12 are filled with a conductive material in order to form interconnect vias connecting the conductive lines 10 of the M0 level to conductive lines of the M1 level. This may be done in a number of ways in terms of the materials used for the interconnect vias and the process steps required for filling the openings and producing the M1 lines. Any known process and material for the via formation and M1 line formation can be applied within the scope of the present invention.

For example, and with reference to Figures 10a and 10b, an additional metal layer may be deposited, for example again a Ru layer, filling the via openings 12 and forming a blanket metal layer on the planarized surface. If Ru is used, a titanium oxide liner is preferably deposited first on the bottom and sidewalls of the via openings 12 and on the planarized surface, for obtaining good adhesion of the Ru. The blanket metal layer formed on the planarized surface is then patterned by direct metal etching in the same manner as described above, to form a second array of conductive lines 13 of the M1 level arranged crosswise with respect to the lines 10 of the M0 level. The interconnect vias 14, one of which is visualised in the section view in Figure 10b, connect a line 10 in the M0 level to a crosswise arranged line 13 in the M1 level. The line 10 is narrower at the via locations than outside the via locations, due to the above-described shrinking of the hardmask lines 4 prior to performing the etch process that creates the conductive lines 10.

The overall result is that the conductive lines of the M0 level are thinner and thereby placed further apart across the majority of their length compared to prior art configurations, except at the locations of interconnect vias which connect these lines to conductive lines of the next level M1. The interconnect vias themselves are self-aligned (in the direction perpendicular to the lines 10) to the wider portions of the conductive lines 10. This is beneficial as it ensures that the process of filling the via openings 12 is not rendered more difficult compared to prior art methods, and that the resistance of the interconnect vias 14 is also the same as in prior art configurations.

As stated, the actual production of the interconnect vias 14 can be done in a number of ways, other than the approach referred to above. According to another approach, the via openings are filled with a metal other than the metal of the conductive lines 10, for example W when the lines 10 are formed of Ru. The vias are then planarized to a common level with the dielectric, and the M1 metal is deposited and patterned, wherein said M1 metal may be another material than the material of the vias.

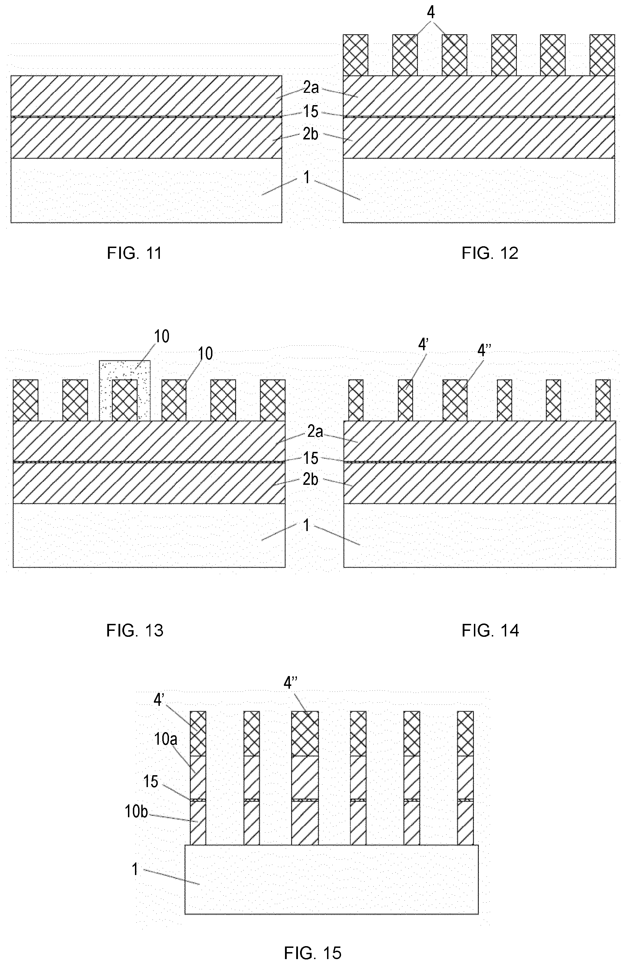

Figure 11 illustrates an alternative embodiment included within the wider scope of the invention. The image is a section view of the same substrate portion 1 shown in Figure 1, i.e. an upper slice of a process wafer after completion of a FEOL process flow. Instead of the integrally formed conductive layer 2 however, a first and second conductive layer 2a,2b is formed on the substrate, with a thin electrically conductive etch stop layer 15 in between the two. The combined height of layers 2a, 2b and 15 may be about the same as the thickness of layer 2 in Figure 2. The material of layers 2a and 2b is the same material, for example Ru, but it is possible also to use different materials for layers 2a and 2b. The method steps are essentially the same as in the first embodiment, while the etch stop layer 15 has a beneficial effect during the step of producing the conductive lines. As illustrated in Figure 12, the formation of the hardmask line pattern consisting of lines 4 takes place in the same manner as in the first embodiment. Also, the formation of the pillars 5 and shrinking of the hardmask lines to form reduced line portions 4' and non-reduced line portions 4" is done in the same way, as illustrated in Figures 13 and 14. Then the hardmask pillars 5 are stripped (Figure 15) and the modified hardmask line pattern is transferred to the underlying layers 2a,15,2b by etching. The etch stop function of etch stop layer 15 is relevant to the etch process for etching layer 2a : in other words, etching layer 2a is stopped by the etch stop layer 15. Another etch recipe is then applied for removing the etch stop layer 15 itself, after which the bottom layer 2b is removed by a suitable etch recipe applicable for the material of layer 2b. The single etch process applied in the first embodiment is therefore replaced by a three-step etch process. Depending on the applied material and thickness of the etch stop layer, this approach may reduce the number of defects caused due to sidewall attack during the direct metal etch process. When the layers 2a and 2b are formed of Ru, both having a thickness between 10 and 30 nm for example, a suitable etch stop layer 15 can be formed of TiN or W, wherein the thickness of the etch stop layer may be in the order of 0.3 to 3 nm. The resulting conductive lines are now formed of a bottom portion 10b, a thin etch stop layer portion 15 and a top portion 10a.

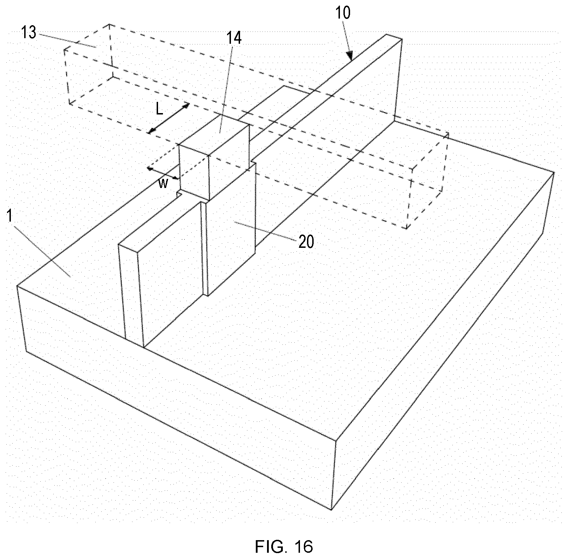

A semiconductor component according to the invention is characterized by a particular profile of the conductive lines of the BEOL interconnect levels, for the production of which the method of the invention has been applied. In these levels, the conductive lines include one or more local line portions having a higher width than the line width outside said local line portions. This is illustrated in Figure 16, which schematically shows a single line 10 of the M0 level, a single line 13 of the M1 level and an interconnect via 14 connecting these two lines and without showing the dielectric material into which the lines are embedded. The local line portion (having a higher width than the line width outside the line portion) is indicated by numeral 20. The M1 line 13 is shown in transparent view in order to visualize the M0 line 10 and the interconnect via 14 located above the local line portion 20. The interconnect via 14 is defined by a width w in the direction perpendicular to the conductive line 10 and by a length L in the longitudinal direction of said line 10. Because the via 14 has been produced in the above-described manner, i.e. by removing material of the non-reduced hardmask portion 4", the width w is equal to and aligned to the width of the local line portions (i.e. the interconnect via is produced in such a manner that the via is self-aligned in the width direction). In the longitudinal line direction, the via length L is at least equal to the length of the local line portion 20. In the embodiment shown, the via length L is smaller than the length of the local line portion 20. This via length L is determined by the mask dimensions used for producing the via openings 12, and can therefore be smaller than the length of the non-reduced hardmask portion 4".

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing an array of parallel conductive lines (10,13) in a first and second level of a multilevel interconnect structure of a semiconductor component, the method comprising the steps of :
- providing a substrate (1) comprising a planar surface formed primarily of dielectric material,
- producing on said planar surface a layer (2) of electrically conductive material,
- producing a hardmask pattern in the form of parallel lines (4) on the layer of conductive material (2),
- producing at least one local hardmask pillar (5) that fully overlaps at least one of said parallel hardmask lines (4), at an intended location of an interconnect via (14) for connecting a conductive line (10) in said first level to a conductive line (13) in a second level directly above the first level,
- reducing the width of the parallel hardmask lines (4) except at the location of the at least one local hardmask pillar (5),
- removing the at least one local hardmask pillar (5), leaving a modified hardmask line pattern comprising hardmask lines which are wider at the location or locations at which the at least one hardmask pillar was present, than outside said pillar location or locations,
- transferring the modified hardmask line pattern to the layer of conductive material (2) by etching, thereby obtaining parallel conductive lines (10), at least one of said lines comprising one or more local line portions (20) having a higher width than the line width outside said local line portions (20),
- producing dielectric material (11) between the conductive lines (10) and planarizing said dielectric material and the hardmask line pattern to a common planar surface,
- removing the material of the hardmask lines at the intended one or more via locations, to thereby obtain one or more via openings (12) in said common planar surface, exposing one or more conductive lines (10) of the first level at the bottom of the respective one or more via openings,
- filling the one or more via openings (12) with a conductive material to thereby obtain one or more interconnect vias (14) suitable for connecting said conductive lines (10) of the first level to conductive lines (13) of the second level,
- producing said conductive lines (13) of the second level, at least some of which are connected to conductive lines (10) of the first level by one or more of said interconnect vias (14).

2. The method according to claim 1, wherein the step of reducing the width of the hardmask lines (4) is done by :
- oxidizing the hardmask lines (4) so that in an outer layer of the hardmask lines, the hardmask material is replaced by an oxide layer,
- removing the oxide layer by etching the oxide layer selectively with respect to the hardmask material of the hardmask lines.

3. The method according to claim 1 or 2, wherein said layer (2) of conductive material comprises a bottom layer (2b), an etch stop layer (15) directly on the bottom layer and a top layer (2a) directly on the etch stop layer, wherein :
- the etch stop layer (15) stops an etch process applied for transferring the hardmask line pattern to said top layer (2a),
- after transferring the hardmask line pattern to the top layer (2a), the line pattern is further transferred by etching to the etch stop layer (15) itself and to the bottom layer (2b).

4. The method according to any one of the preceding claims, wherein said first and second level of the multilevel interconnect structure belong to the three deepest levels of the interconnect structure.

5. The method according to any one of the preceding claims, wherein the layer of conductive material comprises or consists of Ru, Wo or Mo and wherein the hardmask material used for forming the parallel hardmask lines (4) is SiN or SiO₂.

6. A semiconductor component comprising a multilevel interconnect structure, including a first level and a second level, each comprising an array of parallel conductive lines (10,13) and one or more interconnect vias (14) connecting conductive lines of the first level to conductive lines of the second level,
**characterized in that** at least one of the conductive lines (10) of the first level comprises one or more local line portions (20) having a higher width than the line width outside said local line portions, and wherein one or more of said interconnect vias (14) are located at the locations of said local line portions (20), said interconnect vias being defined by a width (w) in the direction perpendicular to the conductive line (10) and by a length (L) in the longitudinal direction of said line (10), and wherein :
- said via width (w) is equal to and aligned to the width of the local line portions (20),
- said via length (L) is at least equal to the length of the local line portions (20).

7. The component according to claim 6, wherein said first and second level of the multilevel interconnect structure belong to the three deepest levels of the interconnect structure.
